# EUROPEAN PATENT APPLICATION

(11) **EP 4 761 089 A1**
(43) Date of publication of application: **17.06.2026**
(21) Application number: 24852349.0
(22) Date of filing: 07.08.2024
(51) Int. Cl.: H02M 7/00, H05K 7/20, H01F 27/08, H02M 3/00, H02M 1/00, H05K 1/02

(54) **PRINTED CIRCUIT BOARD AND POWER CONVERSION DEVICE COMPRISING SAME**

(30) Priority: 07.08.2023 KR 20230103176; 05.08.2024 KR 20240103730
(71) Applicant: LG INNOTEK CO. LTD, Gangseo-gu Seoul 07796 (KR)
(72) Inventor: KWON, Gook Min, Seoul 07796 (KR); LEE, Jeong Ho, Seoul 07796 (KR); CHO, Byung Geuk, Seoul 07796 (KR)
(74) Representative: DREISS Patentanwälte PartG mbB
(86) International application number: PCT/KR2024/011742
(87) International publication number: WO 2025/033996

(57) **Abstract**

A printed circuit board according to one embodiment of the present invention comprises a substrate and a bus bar disposed on the substrate, wherein the bus bar includes: a base spaced a predetermined distance apart from the top surface of the substrate; and two side portions extending from both ends of the base toward the top surface of the substrate.

## Description

### [Technical Fields]

The teachings in accordance with exemplary and non-limiting embodiments of the present invention relate generally to a printed circuit board, and more particularly to a printed circuit board comprising a bent bus bar and a power conversion device comprising the same.

### [Background Arts]

Rapid chargers for electric vehicles support high-speed charging of several hundred kilowatts by configuring power modules with capacities of tens of kilowatts in parallel, thereby outputting high-capacity power. When connected to an electric vehicle, the power module receives AC power from the grid and outputs DC power to charge the vehicle's battery. At this time, to ensure stable charging, voltage, current, and other parameters are sensed, with the sensed information transmitted via signal lines. At this time, placing both the high-current power lines and signal lines on a single substrate can cause noise and may restrict the placement of the signal lines.

### [Summary of Invention]

### [Technical Subject]

The technical problem to be addressed by the present invention is to provide a printed circuit board comprising a bent bus bar and a power conversion device comprising the same.

### [Technical Solution]

To solve the aforementioned technical subject, a printed circuit board according to one embodiment of the present invention may comprise a substrate and a bus bar disposed on the substrate, wherein the bus bar includes: a base spaced a predetermined distance apart from the top surface of the substrate; and two side portions extending from both ends of the base toward the top surface of the substrate.

Preferably, but not necessarily, the bus bar may allow current to flow in a first direction connecting one of the two side portions, the base, and the other of the two side portions.

Preferably, but not necessarily, the current flowing through the bus bar may flow in both directions, including a first direction and the direction opposite to the first direction.

Preferably, but not necessarily, the printed circuit board may further comprise a signal line disposed on the substrate and disposed in a second direction, which may form a predetermined angle with both the first direction and the second direction.

Preferably, but not necessarily, the second direction and the first direction may be orthogonal.

Preferably, but not necessarily, the printed circuit board may further comprise a first signal pattern disposed on the substrate, wherein the first signal pattern may be disposed beneath the base of the bus bar.

Preferably, but not necessarily, the first signal pattern may be disposed in the second direction, and the second direction may be parallel to the width direction of the two side portions.

Preferably, but not necessarily, the portion where the base and the two side portions connect may be formed by bending.

Preferably, but not necessarily, the two side portions may extend from the base in a direction perpendicular to the top surface of the substrate.

Preferably, but not necessarily, the substrate may include two coupling holes for being coupled to the bus bar, and the two side portions may each be coupled to the two coupling holes.

Preferably, but not necessarily, each of the two side portions may include a protrusion at its end corresponding to the shape of the coupling hole, and a region of the end where the protrusion is not formed may contact the top surface of the substrate.

Preferably, but not necessarily, the bus bar may be a power line.

Preferably, but not necessarily, the two side portions of the bus bar may be solder-bonded to the substrate.

To solve the technical subject, a power conversion device according to one embodiment of the present invention may comprise: a substrate; a bus bar disposed on the substrate and forming a power line; and a signal pattern forming a signal line disposed on the substrate, wherein the bus bar comprises a base disposed at a predetermined distance from the top surface of the substrate; and two side portions extending from both ends of the base towards the top surface of the substrate, wherein the signal pattern may be disposed beneath the base.

Preferably, but not necessarily, the bus bar may allow current to flow in a first direction connecting one of the two side portions, the base, and the other of the two side portions.

Preferably, but not necessarily, the signal pattern may be disposed in the second direction and may be orthogonal to both the first direction and the second direction.

### [Advantageous Effects]

According to embodiments of the present invention, by applying a bent bus bar to the PCB substrate, the main power line and signal line can be configured orthogonally, thereby reducing noise. Furthermore, this increases the freedom in arranging surrounding ICs and components, enabling a higher power density.

### [Brief Description of Drawings]

FIG. 1 illustrates a printed circuit board according to an embodiment of the present invention.
FIG. 2 illustrates a bus bar according to an embodiment of the present invention.
FIGS. 3 and 4 are drawings for explaining the connection between the bus bar and the board according to an embodiment of the present invention.
FIGS. 5 and 6 are drawings illustrating the arrangement of signal lines on the printed circuit board according to an embodiment of the present invention.

### [Best Modes]

Hereinafter, the attached drawings are referred to in detail to explain the preferred embodiment of the present invention.

However, the technical idea of the present invention is not limited to the some embodiments described, but can be implemented in various different forms, and within the scope of the technical idea of the present invention, one or more of the components between the embodiments can be selectively combined or replaced.

In addition, the terms used in the embodiments of the present invention (including technical and scientific terms) can be interpreted to mean what a person with ordinary skill in the art would understand, unless explicitly defined and described, and generally understood by a person with ordinary skill in the art. Generally used terms, such as those defined in dictionaries, can be interpreted in the context of the relevant technology.

Furthermore, the terms used in the embodiments of the present invention are intended to explain the embodiments and are not intended to limit the invention.

In this specification, the singular form may include the plural form unless otherwise specified in the text, and when described as 'A and (and/and) B, C, at least one (or more than one) of A, B, and C,' it may include one or more of all combinations of A, B, and C.

In addition, terms such as 1, 2, A, B, (a), and (b) may be used to describe the components of the embodiments of the present invention. Such terms are intended only to distinguish the component from other components and are not limited by the nature, order, or sequence of the component.

Furthermore, if any component is described as being 'connected', 'coupled' or 'attached' to another component, that component may be directly connected, coupled or attached to that other component, as well as being 'connected', 'coupled' or 'attached' to another component that is between that component and that other component.

In addition, when it is stated that each component is formed or disposed 'above or below', the above or below includes not only the case where two components are directly in contact with each other, but also the case where one or more other components are formed or arranged between the two components. In addition, when it is expressed as 'upper or lower', it can include the meaning of the lower direction as well as the upper direction based on one component.

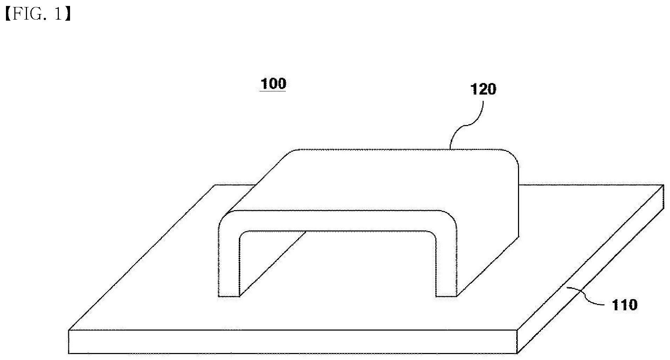

FIG. 1 illustrates a printed circuit board according to an embodiment of the present invention. The printed circuit board (100) according to an embodiment of the present invention may comprise a substrate (110) and a bus bar (120), and may include signal lines (130, 140).

The printed circuit board (PCB) according to an embodiment of the present invention may be a substrate for the power conversion device of an electric vehicle charging apparatus. Here, the power conversion device may be the power module of the electric vehicle charging apparatus, capable of receiving AC power input from the grid and converting it into DC power for charging the electric vehicle battery before output.

The substrate (110) may be a PCB substrate formed in a plate shape.

A bus bar (120) may be disposed on the substrate (110). A bus bar is a metal bar through which current flows and a large current can flow stably through the bus-bar (120).

The bus bar (120) may comprise a base (121) and two side portions (122, 123).

The base (121) has a plate-like shape, and the two side portions (122, 123) extend from both ends of the base (121) towards the top surface of the substrate (110). Through these two side portions (122, 123), the base (121) may be disposed at a predetermined distance spaced apart from the top surface of the substrate (110).

The base (121) may be parallel to the top surface of the substrate (110), and the two side portions (122, 123) may extend in a direction perpendicular to the top surface of the substrate (110) and may be coupled to the substrate (110). The two side portions (122, 123) extend towards the top surface of the substrate (110) but may form a predetermined angle, such as an acute or obtuse angle, relative to the top surface of the substrate (110).

The base (121) and the two side portions (122, 123) may form a bridge configuration on the top surface of the substrate (110), such that the base (121) may form a configuration suspended from the top surface of the substrate (110), and an internal space covered by the underside of the base (121) and the two side portions (122, 123) may be formed.

The connecting portions (124, 125) between the base (121) and the two side portions (122, 123) may be formed by bending. The base (121) and the two side portions (122, 123) may be formed as a single bus bar, with the connecting portions (124, 125) formed by bending.

The bus bar (120) may allow current to flow in a first direction (D1) connecting one of the two side portions (122), the base (121), and the other of the two side portions (123). The two side portions (122, 123) may be connected to the power lines of the substrate (110), with one side portion (122) connected to the input portion and the other (123) connected to the output portion, allowing current input from the input portion to be transmitted to the output portion via the side portion (122), the base (121), and the side portion (123). Here, the input portion is an input portion where the grid's AC power is input, and the output portion may be connected to the power conversion section. Alternatively, the input portion may be an input portion where power converted by the power conversion section is input, and the output portion may be an output portion where DC power is output to the electric vehicle's battery.

The current flowing through the bus bar (120) may flow in both directions, including the first direction (D1) and the opposite direction of the first direction (D1). The power conversion device to which the printed circuit board (100) according to an embodiment of the present invention is applied may be a bidirectional power conversion device, and in this case, it is self-evident that current can flow in both directions through the bus bar (120).

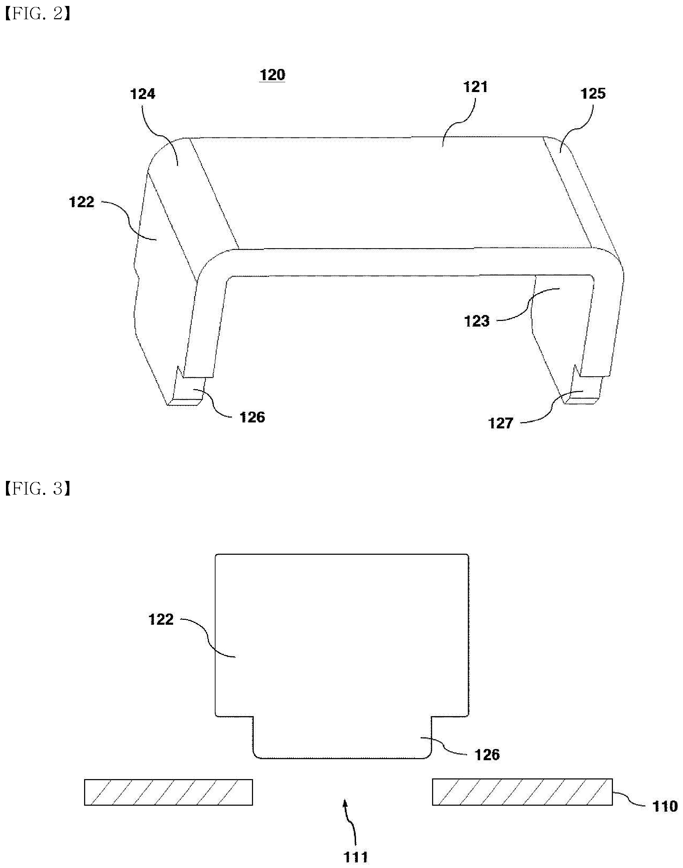

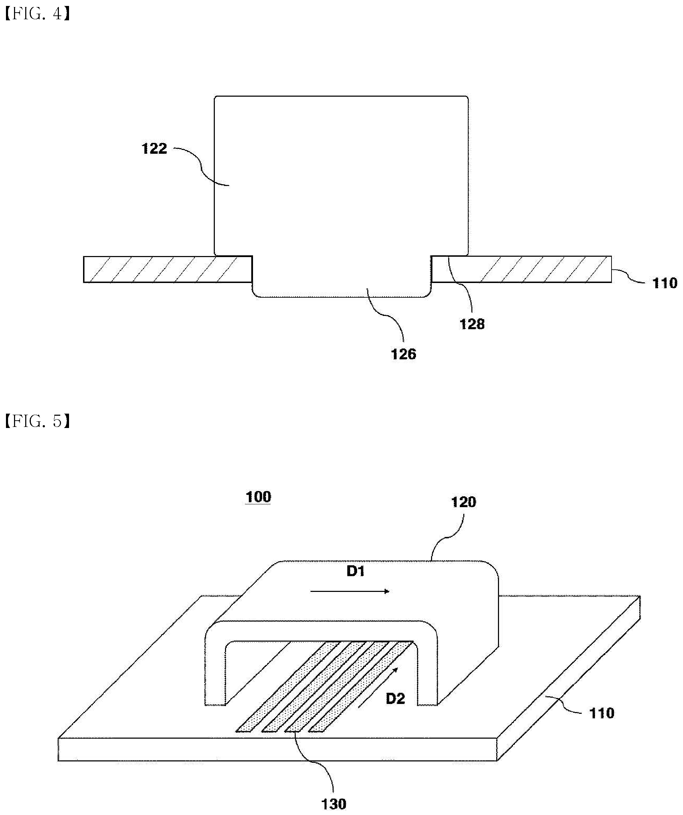

The two side portions (122, 123) extend from the base (121) in a direction perpendicular to the top surface of the substrate (110) and may be coupled to the substrate (110). The substrate (110) may include two coupling holes (111) for coupling to the two side portions (122, 123) of the bus bar (120). The substrate (110) may include the coupling holes (111) as shown in FIG. 3, and the side portions (122) may be coupled to the coupling holes (111) as shown in FIG. 4.

Each of the two side portions (122, 123) may include a protrusion (126, 127) corresponding to the shape of the coupling hole (111) at its end. The two side portions (122, 123) may include protrusions (126, 127) to maintain a distance between the base (121) of the bus bar (120) and the top surface of the substrate (110). The protrusions (126, 127) are inserted into the coupling holes (111) of the substrate (110), and the region (128) at the end where the protrusions (126, 127) are not formed may contact the top surface of the substrate (110). That is, the protrusions (126, 127) are inserted into the coupling hole (111) of the substrate (110) and fixedly coupled to the top surface of the substrate (110), whereas the region (128) at the end without the protrusions (126, 127) is bonded to the top surface of the substrate (110) at a location other than the coupling hole (111) and is not inserted into the coupling hole (111). That is, the two side portions (122, 123) can form a step through a recess forming a catch, thereby securing a clearance distance between the base (121) and the top surface of the substrate (110).

The two side portions (122, 123) of the bus bar (120) may be solder-joined to the substrate (110). The bus bar (120) and the substrate (110) may be joined by soldering, with the protrusions (126, 127) of the two side portions (122, 123) inserted into the coupling holes (111) of the substrate (110). It is evident that the bus bar (120) and the substrate (110) may be joined using other joining methods besides the solder bonding.

The signal lines (130, 140) may be disposed on the substrate (110) and may be disposed in a second direction. The signal lines (130, 140) may include sensing signals sensed by a voltage sensor or a current sensor, etc. The signal flowing through the signal lines (130, 140) is a signal input to the MCU (micro control unit), representing the input-side voltage and other key parameter measurements. Should this signal incur errors or abnormal operation due to noise, it may adversely affect system performance.

The first direction (D1) in which current flows along the bus bar (120) and the second direction (D2) in which the signal lines (130, 140) are disposed may form a predetermined angle. The signal lines (130, 140) and the bus bar (120) may be disposed so as not to be parallel to each other. This reduces interference caused by cross-talk noise.

Here, cross-talk refers to the propagation of signals and noise due to coupling between lines, also known as crosstalk or interference. When two lines (including PCB pattern wiring diagram) are separate, electrical signals and noise should not be conducted. However, when two lines are parallel, noise can be conducted due to the stray capacitance (parasitic capacitor) and mutual inductance existing therebetween, which is termed crosstalk. Therefore, crosstalk can be considered a form of conducted noise. Coupling between lines includes capacitive (static) coupling due to stray capacitance (parasitic capacitors) and inductive (electromagnetic) coupling due to mutual inductance, which can result in noise generation.

The printed circuit board according to the comparative example of the present invention, which does not include the bent bus bar (120) of the present invention, arranges power lines and signal lines on the substrate. In this case, the power lines and signal lines are configured utilizing both the external and internal patterns of the printed circuit board. Depending on the magnitude of the current flowing through the power lines, these power lines may be applied not only to the external layer but also to the internal layers of the printed circuit board. Consequently, the signal lines may need to be disposed using PCB areas where power lines are not disposed. The PCB patterns thus disposed result in a loss of freedom in the placement of ICs and other components. Furthermore, there is an issue that high power density cannot be achieved from a power density perspective. Even if power lines are configured on the external layers and signal lines on the internal layers, the limited PCB thickness (e.g., 2T) restricts the minimum line-to-line spacing to a maximum of 0.5T (based on a 4-layer board), potentially making the design more susceptible to noise.

The printed circuit board (100) according to an embodiment of the present invention can reduce crosstalk by disposing the bus bar (120) and signal lines (130, 140) so that they are not parallel to each other. The first direction (D1) and second direction (D2) in which the bus bar (120) and signal lines (130, 140) are respectively disposed may be mutually orthogonal. When the two lines are mutually orthogonal, cross-talk can be minimized. Furthermore, the base (121) of the bus bar (120) is disposed at a distance from the top surface of the substrate (110), such that the base (121) of the bus bar (120) and the signal lines (130, 140) can be spaced apart. By routing the bus bar (120) and signal lines (130, 140) orthogonally and applying the separation distance, noise can be reduced.

The signal lines may include a first signal pattern (130). The first signal pattern (130) may be disposed on the substrate (110), and the first signal pattern (130) may be disposed beneath the base (121) of the bus bar (120). As described above, the bus bar (120) forms an internal space beneath the base (121) via the base (121) and two side portions (122, 123), and the first signal pattern (130) may be disposed beneath the base (121) in a second direction traversing the said internal space. The first signal pattern (130) may be disposed in the second direction (D2), and the second direction (D2) may be parallel to the width direction of the two side portions (122, 123).

As shown in FIG. 5, the first signal pattern (130) may be disposed beneath the base (121) of the bus bar (120), such that the second direction (D2) is disposed perpendicular to the first direction (D1) in which the side portion (122) of the bus bar (120) - base (121) - the other side portion (123) in a second direction (D2) orthogonal to the first direction (D1). The first signal pattern (130), disposed in a lattice configuration with the bus bar (120), can reduce noise due to crosstalk, as described earlier.

Furthermore, the first signal pattern (130) may be disposed not only spaced apart from the base of the bus bar (120), which is located spaced apart from the top surface of the substrate (110), but also spaced apart from both side portions (122, 123). The first signal pattern (130) can reduce noise not only by being orthogonally arranged in a grid pattern relative to the bus bar (120), but also by maintaining a separation distance.

The first signal pattern (130) and the bus bar (120) may be disposed orthogonally on the substrate (110). The printed circuit board (100) according to an embodiment of the present invention can have a higher power density compared to a printed circuit board according to a comparative example of the present invention that does not include the bent bus bar (120) of the present invention, and it provides increased freedom in the placement of surrounding ICs and components.

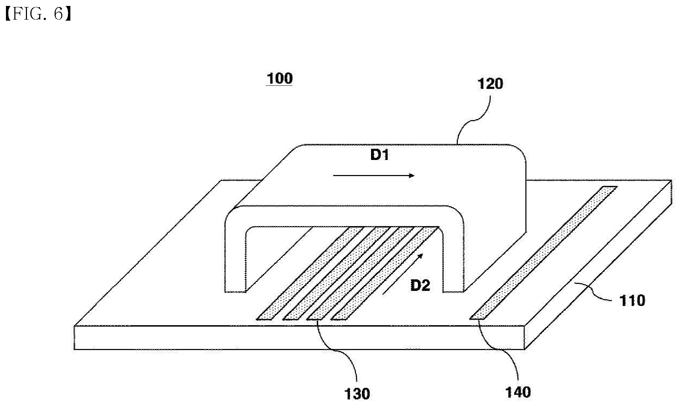

The signal line may include a second signal pattern (140). In addition to the first signal pattern (130) traversing the internal space of the busbar (120), it may also include a second signal pattern (140) spaced apart from the exterior of the bus bar (120) and disposed on the substrate (110) in a second direction (D2). As shown in FIG. 6, the second signal pattern (140) is not disposed within the internal space of the bus bar (120). However, the direction in which the signal is transmitted is the second direction (D2), which is orthogonal to the first direction (D1) of the bus bar (120). This provides the effect of reducing noise due to crosstalk.

The power conversion device according to an embodiment of the present invention may comprise a substrate, a bus bar, and a signal pattern. The detailed description of the power conversion device according to an embodiment of the present invention corresponds to the detailed description of the printed circuit board (100) in FIGS. 1 to 6 and therefore, redundant descriptions are omitted hereafter.

The power conversion device according to an embodiment of the present invention may comprise a substrate, a bus bar disposed on the substrate and forming a power line, and a signal pattern forming a signal line disposed on the substrate. wherein the bus bar comprises a base disposed at a predetermined distance from the top surface of the substrate and two side portions extending from both ends of the base towards the top surface of the substrate, and the signal pattern may be disposed beneath the base.

Current flows through the bus bar in a first direction connecting one of the two side portions, the base, and the other of the two side portions, and the signal pattern may be disposed in a second direction, which may be orthogonal to the first direction and the second direction.

A person skilled in the art relating to the present embodiments will understand that the disclosed methods may be implemented in modified forms without departing from the essential characteristics of the above-described embodiments. Therefore, the disclosed methods should be considered from an illustrative perspective rather than a restrictive one. The scope of the present invention is defined not by the foregoing description but by the appended claims, and all differences within the scope of the claims shall be interpreted as falling within the scope of the present invention.

## Claims

1. A printed circuit board, comprising:
a substrate; and
a bus bar disposed on the substrate,
wherein the bus bar comprises:
a base spaced a predetermined distance apart from a top surface of the substrate; and
two side portions extending from both ends of the base toward the top surface of the substrate.

2. The printed circuit board of claim 1, wherein the bus bar is configured to allow current to flow in a first direction connecting one of the two side portions, the base, and the other of the two side portions.

3. The printed circuit board of claim 2, wherein the current flowing through the bus bar flows in both directions, including a first direction and a direction opposite to the first direction.

4. The printed circuit board of claim 2, comprising:
a signal line disposed on the substrate and disposed in a second direction,
wherein the second direction forms a predetermined angle with the first direction.

5. The printed circuit board of claim 4, wherein the second direction and the first direction are orthogonal.

6. The printed circuit board of claim 1, comprising:
a first signal pattern disposed on the substrate,
wherein the first signal pattern is disposed beneath the base of the bus bar.

7. The printed circuit board of claim 6, wherein the first signal pattern is disposed in a second direction, and the second direction is parallel to a width direction of the two side portions.

8. The printed circuit board of claim 1, wherein a portion where the base and the two side portions are connected is formed by bending.

9. The printed circuit board of claim 1, wherein the two side portions extend from the base in a direction perpendicular to the top surface of the substrate.

10. The printed circuit board of claim 1, wherein the substrate comprises two coupling holes coupled to the bus bar, and
wherein the two side portions are respectively coupled to the two coupling holes.
